(19) Europäisches Patentamt
European Patent Office
Office européen des brevets

(11) Veröffentlichungsnummer : **0 373 474 B1**

(12) # EUROPÄISCHE PATENTSCHRIFT

(45) Veröffentlichungstag der Patentschrift : **05.04.95 Patentblatt 95/14**

(51) Int. Cl.$^6$ : **G03F 7/40**

(21) Anmeldenummer : **89122352.1**

(22) Anmeldetag : **04.12.89**

(54) **Verfahren zur Herstellung einer ozonresistenten Flexodruckform.**

(30) Priorität : **13.12.88 DE 3841854**

(43) Veröffentlichungstag der Anmeldung : **20.06.90 Patentblatt 90/25**

(45) Bekanntmachung des Hinweises auf die Patenterteilung : **05.04.95 Patentblatt 95/14**

(84) Benannte Vertragsstaaten : **DE FR GB IT**

(56) Entgegenhaltungen :
**EP-A- 0 160 468**
**DE-A- 2 263 804**

(73) Patentinhaber : **E.I. DU PONT DE NEMOURS AND COMPANY**
**1007 Market Street**
**Wilmington Delaware 19898 (US)**

(72) Erfinder : **Schlosser, Hans-Joachim, Dr.-Dipl.-Chem.**
**Am Rosengarten 2a**
**D-6200 Wiesbaden (DE)**

(74) Vertreter : **Pistor, Wolfgang et al**
**Du Pont de Nemours (Deutschland) GmbH**
**Patentabteilung**
**Dornhofstrasse 10**
**D-63263 Neu-Isenburg (DE)**

EP 0 373 474 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Die Erfindung betrifft ein Verfahren zur Herstellung einer ozonresistenten Flexodruckform auf der Basis eines photopolymerisierbaren elastomeren Gemisches.

Elastomere, insbesondere auf der Basis von Butadien oder Isopren für die Herstellung von Flexodruckformen sind seit langem bekannt und werden z.B. in den DE-B 22 15 090 (= US-A 4 423 135), DE-A 21 38 582 (= GB-A 1 358 062), 22 23 808 (= GB-A 1 395 822), DE-B 28 15 678 (= GB-A 1 577 706), DE-A 24 56 439 (= US-A 4 162 919) und 29 42 183 (= US-A 4 320 188) beschrieben. Es konnte allerdings festgestellt werden, daß Flexodruckformen, die diese Elastomere enthalten, schon bei geringster Anwesenheit von Ozon spröde werden und Risse aufweisen.

Das Ozon, das diesen Platten gefährlich wird, entsteht sowohl bei der bildmäßigen Belichtung der photopolymerisierbaren elastomeren Schicht, insbesondere bei Verwendung von UV-Licht, aber auch bei der Anwendung der belichteten und entwickelten Druckformen. Gerade hierbei treten besonders hohe Ozonkonzentrationen auf, insbesondere dann, wenn flexible Verpackungsmaterialien wie Papier oder Kunststoffe bedruckt werden sollen. Der Grund ist darin zu suchen, daß infolge der Gewährleistung einer genügenden hohen Haftung der Druckfarbe, z.B. auf den Kunststoffolien, diese vor dem Bedrucken coronabehandelt werden. Da bei der Coronabehandlung erhebliche Mengen an Ozon entstehen und die Behandlung dann am wirkungsvollsten ist, wenn diese unmittelbar vor dem Druckvorgang stattfindet, gerät die Druckform in erheblichem Maße mit dem aus diesem Prozess entstehenden Ozon in Kontakt. Erhöht wird die Anfälligkeit der entwickelten Druckform gegenüber Ozon noch dadurch, daß in den meisten Fällen eine Nachbehandlung der Druckformen mit Halogen, insbesondere mit Brom, erfolgt, die notwendig ist, um deren Klebrigkeit zu reduzieren.

Um die Resistenz der Druckform gegenüber dem rissebildenden und die Sprödigkeit fördernden Ozon zu verbessern, wurden verschiedene Wege eingeschlagen:

Aus der DE-A-22 15 090 ist bekannt, die Ozonresistenz durch Zusätze zu dem photopolymerisierbaren Gemisch zu verbessern. Als Zusätze werden mikrokristallines Wachs und Paraffinwachs, Dibutylthioharnstoff, 1,1,3,3-Tetramethylthioharnstoff, Norbornen, N-Phenyl-2-naphthylamin, ungesättigte Pflanzenöle, Ethylen/Vinylacetat-Copolymerisate, Polyurethane, chlorierte und/oder chlorsulfonierte Polyethylene, chlorierte Ethylen/Methacrylsäure-Copolymerisate, Polypentadiene, von Furfurol abgeleitete Harze, Ethylen/Propyldien-Kautschuke, Diethylenglykolester von Harzen und Copolymerisate von alpha-Methylstyrol mit Vinyltoluol.

Der Nachteil dieser Methode ist, daß die genannten Zusätze oftmals nicht ausreichen, um die geforderte Resistenz gegenüber Ozon zu gewährleisten, oder, wenn die wirksame Konzentration dieser Zusätze erhöht wird, das photopolymerisierbare Gemisch Trübungen in solchem Ausmaß aufweist, daß eine einwandfreie Bebilderung nicht mehr erzielt werden kann.

Ein anderes Verfahren zum Schutz einer Flexodruckform gegenüber Ozon wird in der DE-A 35 12 632 (= US-A 4 680 251) beschrieben. Dieses Verfahren fußt nicht auf irgendwelchen Zusätzen zu dem photopolymerisierbaren Gemisch, sondern beschreibt eine Nachbehandlung der entwickelten und mit Halogen behandelten Druckform mit bestimmten Polyglykolverbindungen. Die beschriebenen Polyglykolverbindungen sind entweder nicht oder nur monoverethert. Allerdings zeigten Flexodruckformen, die mit diesen Polyglykolverbindungen behandelt worden waren, schon nach kurzer Zeit ihres Aufenthaltes in ozonhaltiger Luft erste Rißbildungen.

Es bestand deshalb die Aufgabe, ein Verfahren zur Behandlung von Flexodruckfornien auf der Basis eines photopolymerisierbaren elastomeren Gemisches bereitzustellen, welches eine genügend hohe Ozonresistenz gewährleistet.

Gelöst wird die Aufgabe durch ein Verfahren der eingangs genannten Gattung, das dadurch gekennzeichnet ist, daß ein Behandlungsreagenz auf die entwickelte und ggf. in üblicher Weise nachbehandelte Flexodruckform aufgetragen wird, das als wesentlichen Bestandteil mindestens einen Polyglykolether der allgemeinen Formel I

$$R_1-O-(A)_l-(\underset{\left[\begin{array}{c}D\\|\\O\\|\\R_3\end{array}\right]_o}{\underset{|}{B}})_m-(C)_n-R_2 \qquad (I)$$

enthält, worin

| | |
|---|---|
| $R_1$ und $R_2$ | Alkyl, insbesondere ($C_1$-$C_3$)Alkyl, |
| $R_3$ | Wasserstoff oder Alkyl, insbesondere ($C_1$-$C_3$)Alkyl, |
| A, B, C und D | gleich oder verschieden sein können und Oxa-n- oder -iso-alkylen, insbesondere Oxa-n- |

oder -iso-($C_1$-$C_5$)alkylen und

l+m+n+o 3 bis 40

bedeuten.

Bevorzugt ist, wenn m und o > 0 und o ≦ m gilt, sowie $R_3$ ($C_1$-$C_3$)Alkyl bedeutet. Insbesondere ist o und m gleich l.

Ist o≠0, so ist D vorzugsweise gleich A oder C, und B bedeutet in diesem Fall einen Oxa-n-alkylen-, insbesondere einen Oxa-n-($C_3$ oder $C_5$)alkylen-Rest.

Besonders bevorzugt ist aber, wenn o=0 ist, und die Summe aus l, m und n 3-40 ergibt.

Eine weitere bevorzugte Ausführungsform liegt vor, wenn A gleich C, aber ungleich B bedeutet. In diesem Fall wird bevorzugt, daß A bzw. C ein Oxa-n-($C_2$-$C_4$)alkylen und B ein Oxa-n- oder -iso-($C_2$ oder $C_3$)alkylen-Rest bedeutet. Insbesondere wird hierbei für B ein Oxa-iso-alkylen-Rest bevorzugt.

Weiterhin bevorzugt ist, wenn m=0 bedeutet (d.h. auch o=0), und die Summe aus l und n 3-40 erreicht. A und C stehen in diesem Fall für Oxa-n- oder iso-($C_1$-$C_5$)alkylen, insbesondere für Oxa-n- oder -iso-($C_2$ oder $C_3$)alkylen, wobei A oder C mindestens in der Weise unterschiedlich sind, daß sie nicht gemeinsam einen Oxa-n-oder einen Oxa-iso-alkylen-Rest bedeuten.

Bevorzugt ist aber eher diejenige Variante, in der l und m bzw. m und n jeweils gleich 0 bedeuten. In diesem Fall ist C bzw. A ein Oxa-n- oder -iso-($C_2$-$C_5$)alkylen, insbesondere ein Oxa-n- oder -iso-($C_2$ oder $C_3$)alkylen.

$R_1$ und $R_2$ bedeuten in allen Fällen ($C_1$-$C_3$)Alkyl. Insbesondere sind $R_1$ und $R_2$ gleich und besonders bevorzugt Methyl.

Das mittlere Molekulargewicht des Polyglykolethers gemäß der allgemeinen Formel I beträgt 100 bis 1.400, insbesondere 200 bis 1.200, besonders bevorzugt 200 bis 600.

In einer besonderen Ausführungsform enthält das erfindungsgemäße Behandlungsreagenz lediglich einen Polyglykolether gemäß der allgemeinen Formel I.

Es war besonders überraschend, daß eine Nachbehandlung mit dem beschriebenen Polyglykoldialkylether zu einer solch hohen Ozonresistenz führt, nachdem die Verwendung der entsprechenden Monoalkylether ein mit diesen vergleichbare Wirkungsweise erwarten ließ und damit eher von der Austestung von Dialkylethern abhielt.

Die Behandlungslösung des erfindungsgemäßen Verfahrens enthält mindestens 50 Gew.-%, vorzugsweise mindestens 80 Gew.-%, und besonders bevorzugt ausschließlich zumindest eine Verbindung, die unter die beschriebene allgemeine Formel I fällt. Insbesondere bevorzugt ist, wenn die Behandlungslösung lediglich eine Verbindung der allgemeinen Formel I enthält.

Sofern die Behandlungslösung nicht ausschließlich aus Verbindungen der allgemeinen Formel I besteht, kann sie als Mischung auch Behandlungsreagenzien des Standes der Technik enthalten, wie z.B. Polyglykolether der DE-A-35 12 632, aber auch Lösemittel wie halogenierte Kohlenwasserstoffe, Alkohole, aromatische Kohlenwasserstoffe, Terpene, Ester und Phenolether. Diese Ausgestaltung ist aber nicht bevorzugt.

Nach dem erfindungsgemäßen Verfahren wird die beschriebene Behandlungslösung nach der Entwicklung des Aufzeichnungsmaterials und ggf. nach einer Behandlung der entstandenen Flexodruckform mit Halogen, insbesondere mit Brom, aufgetragen. Das Auftragen kann sowohl in einem Auftupfen, z.B. mit einem Baumwolltupfer, Pinsel oder Schwamm erfolgen, oder aber auch in einem Eintauchen der Flexodruckform in ein Bad, enthaltend die Behandlungslösung, bestehen. Die überflüssige Behandlungslösung wird anschließend z.B. mittels Abtropfens oder eines Tupfers entfernt. Eventuell kann die in der erfindungsgemäßen Weise behandelten Flexodruckform auch noch erwärmt werden, beispielsweise um die Konzentration der Behandlungslösung auf der Flexodruckform zu modifizieren.

Die mit der beschriebenen Behandlungslösung im erfindungsgemäßen Verfahren behandelten Flexodruckformen enthalten als elastomeres Bindemittel vorwiegend Polymerisate aus konjugierten aliphatischen Dienen mit 4 bis 5 C-Atomen. Insbesondere sind zu nennen: Naturkautschuke, Homo- oder Co-polymerisate von Butadien und Isopren, Copolymerisate von Butadien und/oder Isopren mit anderen Monomeren wie Styrol, Vinyltoluol, Acrylnitril oder (Meth)Acrylsäureester, z.B. Nitrilkautschuke, statistische Styrol/Butadien-, Styrol/Isopren-, und Styrol/Isopren/Butadien-Copolymerisate oder auch Blockcopolymerisate aus Styrolmonomeren und Butadien und/oder Isopren mit einem Styrolgehalt von 10 bis 50 Gew.-%. Elastomere Bindemittel dieser Art sind in der DE-A-22 15 040 beschrieben.

Das, im erfindungsgemäßen Verfahren eingesetzte photopolymerisierbare Gemisch enthält im allgemeinen 20 bis 98 Gew.-%, vorzugsweise 30 bis 95 Gew.-%, wenigstens einer der genannten elastomeren Bindemitteltypen. Es enthält weiterhin mindestens eine radikalisch polymerisierbare, olefinisch ungesättigte Verbindung sowie mindestens einen Photoinitiator.

Geeignete Monomere mit einer oder mehreren polymerisierbaren olefinischen Doppelbindungen sind insbesondere Ester und Amide von Acryl- und Methacrylsäure. Beispiele sind die verträglichen Mono- und Diacrylate und -methacrylate von ein- oder mehrwertigen Alkoholen wie Ethylenglykol, Di-, Tri-, Tetra- oder Polyethylenglykolen, letztere bevorzugt mit 10 bis 15 Ethylenglykoleinheiten, 1,3-Propandiol, 1,6-Hexandiol, Dodecandiol, Glycerin, 1,1,1-Trimethylolpropan, 1,2,4-Butantriol oder Pentaerythrit, z. B. Ethylenglykol-monomethacrylat, 1,3-Propandiolmonomethacrylat, Glycerinmono- und -diacrylat, Hexandioldiacrylat, Hexandioldimethylacrylat, 2-Ethylhexylacrylat, Laurylmethacrylat, Stearylmethacrylat, 1,2,4-Butantriolmonomethacrylat, Pentaerythrittriacrylat, Polyethylenglykolmethyletheracrylat, Tetradecaethylenglykol-dimethacrylat oder der Triether aus Glycerin und 3 mol N-Methylolacrylamid oder -methacrylamid. Ebenso sind Alkenylphosphon- und -phosphinsäureester nach der P 38 17 424.3 anwendbar. Die Menge an Monomeren liegt im allgemeinen bei etwa 1 bis 70, bevorzugt bei etwa 2 bis 50 Gew.-% der nichtflüchtigen Betandteile des Gemischs.

Als Photoinitiatoren werden im photopolymerisierbaren Gemisch bekannte Verbindungen eingesetzt, die eine hinreichende thermische Stabilität bei der Verarbeitung der Aufzeichnungsmaterialien sowie eine hinreichende Radikalbildung bei Belichtung unter Initiierung der Polymerisation der Monomeren aufweisen. Sie sollen Licht im Wellenlängenbereich von ca. 250 bis ca. 500 nm unter Bildung von Radikalen absorbieren. Beispiele geeigneter Photoinitiatoren sind Acyloine und deren Derivate wie Benzoin, Benzoinalkylether, z. B. Benzoinisopropyletherl vicinale Diketone und deren Derivate, z. B. Benzil, Benzilacetale wie Benzildimethylketal, Fluorenone, Thioxanthone, Mehrkernchinone, Acridine und Chinoxaline; ferner Trichlormethyl-s-triazine, 2-Halogenmethyl-4-vinyl-1,3,4-oxadiazolderivate, mit Trichlormethylgruppen substituierte Halogenoxazole, Trihalogenmethylgruppen enthaltende Carbonylmethylenheterocyclen gemäß DE-A 33 33 450, Acylphosphinoxidverbindungen, wie sie z. B. in der DE-A 31 33 419 beschrieben sind, und andere phosphorhaltige Photoinitiatoren, z. B. die in der älteren deutschen Patentanmeldung P 38 27 735.2 beschriebenen 6-Acyl-(6H)-dibenz[c,e] [1,2]-oxaphosphorin-6-oxide, insbesondere das 6-(2,4,6-Trimethylbenzoyl)-(6H)-dibenz-[c,e] [1,2]-oxaphosphorin-6-oxid. Die Photoinitiatoren lassen sich auch in Kombination miteinander oder mit Coinitiatoren bzw. Aktivatoren verwenden, z. B. mit Michlers Keton und seinen Derivaten oder 2-Alkyl-anthrachinonen. Die Menge an Photoinitiator beträgt im allgemeinen etwa 0,01 bis 10, bevorzugt etwa 0,5 bis 5 Gew.-% des Aufzeichnungsmaterials.

Oft ist es von Vorteil, dem Aufzeichnungsmaterial noch weitere Hilfs- und Zusatzstoffe zuzugeben, z. B. Inhibitoren der thermischen Polymerisation wie Hydrochinon und seine Derivate, 2,6-Di-tert.-butyl-p-kresol, Nitrophenole, Nitrosamine wie N-Nitrosodiphenylamin oder Salze des N-Nitrosocyclohexylhydroxylamins, z. B. dessen Alkali- oder Aluminiumsalze. Weitere übliche Zusätze sind Farbstoffe, Pigmente, Weichmacher, Lichthofschutzmittel, Antioxidantien, Vernetzungsmittel, Regler, Füllmittel, Flußmittel und weitere die Schicht in ihrer Funktion verbessernden Hilfsmittel.

Das photopolymerisierbare Gemisch läßt sich für die Herstellung von Relief- und Flexodruckplatten durch Gießen aus Lösung eines organischen Lösemittels durch Verkneten bei höherer Temperatur und anschließendem Verpressen verwenden. Die Herstellung kann auch durch Extrudieren in einem Ein- oder Zweischneckenextruder und anschließendem Ausformen durch ein Glättwerk oder einem Kalander zu Schichten einer Dicke von 0,02 bis 10, vorzugsweise von 0,4 bis 6 mm, erfolgen. Ebenso ist die Herstellung nach dem Rollerhead-Verfahren möglich. Die Schicht kann auf die Oberfläche eines geeigneten Trägers laminiert oder eine Lösung der erfindungsgemäßen Gemische kann auf einen Schichtträger aufgebracht werden.

Außer für die Herstellung von Flexodruckformen kann das photopolymerisierbare Gemisch auch z. B. zur Herstellung von Flachdruckplatten, Tiefdruckzylindern, Siebdruckschablonen und Photoresists verwendet werden.

Geeignete Träger sind je nach Verwendungszweck z. B. Polyesterfolien, Stahl- oder Aluminiumbleche, Kupferzylinder, Siebdruckschablonenträger, Schaumstofflagen, gummielastische Träger oder Leiterplatten. Es kann auch vorteilhaft sein, auf die lichtempfindliche Aufzeichnungsschicht eine Deck- bzw. Schutzschicht, z. B. eine dünne Schicht aus Polyvinylalkohol, oder eine abziehbare Deckfolie, z. B. aus Polyethylenterephthalat oder Polyamid, aufzubringen. Weiterhin kann eine Vorbeschichtung des Trägers vorteilhaft sein. Die zusätzliche Schicht zwischen dem Träger und der lichtempfindlichen Schicht kann z. B. als Lichthofschutzschicht oder als Haftschicht wirksam sein.

Das aus Träger und photopolymerisierbarer Schicht entstandene Aufzeichnungsmaterial wird bildmäßig mit aktinischem Licht aus Lichtquellen wie Quecksilberdampflampen oder Leuchtstoffröhren belichtet werden, wobei die emittierte Wellenlänge bevorzugt zwischen 300 und 420 nm liegt.

Das Entfernen der unbelichteten und unvernetzten Schichtanteile kann durch Sprühen, Waschen oder Bürsten mit chlorierten Kohlenwasserstoffen, Estern, aromatischen Verbindungen oder Phenolethern, wie sie in der DE-A 22 15 090 und den nicht vorveröffentlichten deutschen Patentanmeldungen P 38 36 402.6, P 38 36 403.4 und 38 36 404.2 beschrieben werden, erfolgen. Der Lösung können ferner kleine Mengen Entschäumer oder mischbare organische Lösemittel, z. B. niedere aliphatische Alkohole, zugesetzt werden. Je nach verwendetem Bindemittel kann auch mit Wasser oder wäßrigen Lösungen entwickelt werden. Zweckmäßig werden die entwickelten Reliefformen bei Temperaturen bis 120 °C getrocknet und gegebenenfalls gleichzeitig

oder danach mit aktinischem Licht nachbelichtet. Nach dem Trocknen der Flexodruckform kann diese mit einer halogenhaltigen Lösung, wie z.B. einer Brom- oder Chlorlösung, nachbehandelt werden. Ebenso ist eine Nachbehandlung mit aktinischer Strahlung, insbesondere mit einer Wellenlänge von < 300 nm, möglich. Vor der bildmäßigen Belichtung kann von der gegenüberliegenden Seite kurzzeitig ebenfalls mit aktinischem Licht vollflächig belichtet werden.

Das Aufzeichnungsmaterial eignet sich besonders zur Herstellung von Druckformen, vor allem Hoch- oder Reliefdruckformen, die besonders für den Flexodruck geeignet sind.

Die Erfindung wird durch die nachstehenden Beispiele erläutert. In den Beispielen steht Gt für Gewichtsteile, wenn nichts anderes angegeben, stehen g:$cm^3$ wie 1:1.

Beispiel 1 (Vergleichsbeispiel)

Es wurde ein photopolymerisierbares elastomeres Gemisch hergestellt, bestehend aus

| | |
|---|---|
| 90 Gt | eines Styrol/Isopren/Styrol-Dreiblockcopolymeren mit einem Gehalt von 30 Gew.-% an Styrol, |
| 8 Gt | Hexandioldiacrylat, |
| 2 Gt | Benzildimethylketal und |
| 0,3 Gt | 2,6-Di-tert.-butyl-4-methylphenol in |
| 20 Gt | eines medizinischen Weißöls (Brechzahl = 1,479 nach DIN 51423 TI) und |
| 100 Gt | Toluol. |

Das Gemisch wurde auf eine 125 µm dicke, biaxial verstreckte und thermofixierte Polyesterfolie in einem Metallrahmen zu einer 6 mm dicken Schicht ausgegossen. Nach dem Verdunsten des Toluols wurde auf die freie Oberfläche der nun 3 mm dicken festen Photopolymerschicht eine mit einer Haftschicht versehene, 125 µm dicke, biaxial verstreckte und thermofixierte Polyesterfolie aufgelegt und das entstandene Dreischichtenelement in einer Plattenpresse bei 110° C unter Verwendung von 2,7 mm dicken Distanzstücken bei einem Druck von 400 N/$cm^2$ 5 min gepreßt.

Nach dem Abziehen derjenigen Polyesterfolie, die nicht mit einem Haftvermittler behandelt worden war, wurde an deren Stelle ein Overcoat aus Polyamid in einer Dicke von 3-4 µm auflaminiert. Zuerst erfolgte eine vollflächige Belichtung der photopolymeren Schicht durch die verbliebene Polyesterfolie. Hierzu wurde das Mehrschichtenelement der Strahlung eines handelsüblichen UV-A-Flachbelichters (Spektralbereich 320-400 nm, Intensität der Strahlung an der photopolymeroberfläche: 14 mW/$cm^2$) für 10 s ausgesetzt. Anschließend erfolgte die bildmäßige Belichtung auf derselben Strahlungsquelle für 30 min, jedoch von der anderen Seite des Mehrschichtenelements aus.

Entwickelt wurde mit Perchlorethylen. Nach dem Trocknen der entstandenen Flexodruckform wurde mit einer 0,4-Gew.-%igen wäßrigen Bromlösung 5 min nachbehandelt, worauf 10 min mit Wasser gespült wurde.

Die Flexodruckform wurde anschließend für 10 min im handelsüblichen UV-A-Flachbelichter nachbelichtet.

Anschließend wurde die Flexodruckform auf einen Zylinder von 7 cm Durchmesser gespannt und in einer Kammer ozonhaltiger Luft (0,5 ppm Ozon) bei Raumtemperatur ausgesetzt. Die Platte wurde zum einen danach beurteilt, zu welcher Zeit sich erste Risse zeigen (ohne Vergrößerung sichtbar), und danach, wieviel Risse nach einer 20stündigen Ozonbehandlung bei Raumtemperatur entstanden sind. Erste Risse traten schon nach 3 h auf. Die Ergebnisse sind in Tabelle I zusammengefaßt.

Beispiel 2 (Vergleichsbeispiel)

Es wurde eine Flexodruckform entsprechend Beispiel 1 hergestellt. Die mit Brom nachbehandelte Druckform wurde anschließend für 20 s in Tripropylenglykolmonomethylether getaucht und danach die überschüssige Flüssigkeit abgetupft. Erste Risse der Druckform traten schon nach 2,5 h Ozonbehandlung (0,5 ppm) auf. Die Ergebnisse sind aus Tabelle 1 ersichtlich.

Beispiel 3 (Vergleichsbeispiel)

Es wurde eine Flexodruckform entsprechend Beispiel 1 hergestellt. Die mit Brom nachbehandelte Druckform wurde anschließend für 20 s in Polypropylenglykol 1.200 getaucht und danach die überschüssige Flüssigkeit abgetupft. Erste Risse traten in der Ozonkammer (0,5 ppm Ozon) schon nach 2 h auf. Die Ergebnisse sind in Tabelle 1 zusammengefaßt.

Beispiel 4

Es wurde eine Flexodruckplatte nach Beispiel 1 hergestellt. Die mit Brom nachbehandelte Druckform wurde anschließend für 20 s in Triethylenglykoldimethylether getaucht und anschließend die überschüssige Flüssigkeit abgetupft. In der Ozonkammer trat erst nach 12,5 h ein Riß auf. Die Ergebnisse zeigt Tabelle 1.

Beispiel 5

Es wurde entsprechend Beispiel 1 eine Flexodruckplatte hergestellt und mit Brom nachbehandelt. Die Druckform wurde anschließend für 20 s in Polyethylenglykoldimethylether 250 getaucht. Nach Abtupfen der Flüssigkeit wurde die Platte Luft mit einem Ozongehalt von 0,5 ppm ausgesetzt. Auch bei einer 20stündigen Behandlung konnten keine Risse festgestellt werden.

Beispiel 6

Es wurde entsprechend Beispiel 1 eine Flexodruckplatte hergestellt und mit Brom nachbehandelt. Die Druckform wurde anschließend für 20 s in polyethylenglykoldimethylether 500 getaucht. Nach Abtupfen der überschüssigen Flüssigkeit wurde die Platte Luft mit einem Ozongehalt von 0,5 ppm ausgesetzt. Erst nach einer Behandlungszeit von 12,5 h konnten erste Risse wahrgenommen werden.

Tabelle 1

Aussetzen der erfindungsgemäß behandelten Flexodruckformen ozonhaltiger Luft (0,5 ppm Ozon)

| Beispiel | Beginn der Rißbildung | Rißhäufigkeit nach 20 h (Anzahl der Risse) |
|---|---|---|
| 1 | 3 h | einige |
| 2 | 2,5 h | einige |
| 3 | 2 h | einige |
| 4 | 12,5 h | einer |
| 5 | nach 20 h | keine |
| 6 | 12,5 h | wenige |

Tabelle 1 verdeutlicht, daß die erfindungsgemäß nachbehandelten Flexodruckformen in überraschender Weise resistenter gegenüber ozonhaltiger Luft sind als Flexodruckformen, die bisher dem Fachmann bekannt waren.

**Patentansprüche**

1. Verfahren zur Herstellung einer ozonresistenten Flexodruckform auf der Basis eines photopolymerisierbaren elastomeren Gemisches, dadurch gekennzeichnet, daß auf die entwickelte und ggf. nachbehandelte Flexodruckform ein Behandlungsreagenz aufgetragen wird, das als wesentlichen Bestandteil mindestens einen Polyglykolether der allgemeinen Formel I

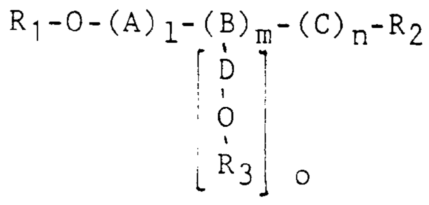 (I)

enthält, worin

| | |
|---|---|
| $R_1$ und $R_2$ | Alkyl, insbesondere $(C_1-C_3)$Alkyl, |
| $R_3$ | Wasserstoff oder Alkyl, insbesondere $(C_1-C_3)$Alkyl, |
| A, B, C und D | gleich oder verschieden sein können und Oxa-n- oder -iso-alkylen, insbesondere Oxa-n- oder -iso-$(C_1-C_5)$alkylen und |
| l+m+n+o | 3 bis 40 |

bedeuten.

2. Verfahren nach Anspruch 1, dadurch gekennzeichnet, daß im Behandlungsreagenz nach Formel I für m und o > 0

| | |
|---|---|
| D | A oder C, |
| B | Oxa-n-alkylen, insbesondere Oxa-n-($C_3$ oder $C_5$)alkylen und |
| $R_1$, $R_2$ und $R_3$ | $(C_1-C_3)$Alkyl |

bedeuten.

3. Verfahren nach Anspruch 1, dadurch gekennzeichnet, daß im Behandlungsreagenz nach Formel I für m=0 und o=0 die Summe aus l und n 3 bis 40 ergibt und

| | |
|---|---|
| A und C | Oxa-n- oder -iso-$(C_1-C_5)$alkylen, insbesondere Oxa-n- oder -iso-($C_2$ oder $C_3$)alkylen, sowie |
| $R_1$ und $R_2$ | $(C_1-C_3)$Alkyl |

bedeuten.

4. Verfahren nach den Ansprüchen 1 oder 3, dadurch gekennzeichnet, daß im Behandlungsreagenz nach Formel I

für l und m gleich 0

C Oxa-n- oder iso-$(C_2-C_5)$alkylen, insbesondere Oxa-n- oder -iso-($C_2$ oder $C_3$)alkylen

und für m und n gleich 0

| | |
|---|---|
| A | Oxa-n- oder -iso-$(C_2-C_5)$alkylen, insbesondere Oxa-n- oder -iso-($C_2$ oder $C_3$)alkylen sowie jeweils |
| $R_1$ und $R_2$ | $(C_1-C_3)$Alkyl, insbesondere Methyl bedeuten. |

5. Verfahren nach einem oder mehreren der Ansprüche 1 bis 4, dadurch gekennzeichnet, daß das Behandlungsreagenz nach Formel I ein mittleres Molekulargewicht von 100 bis 1.400, insbesondere 200 bis 1.200, aufweist.

6. Verfahren nach einem oder mehreren der Ansprüche 1 bis 5, dadurch gekennzeichnet, daß das polymerisierbare elastomere Gemisch im wesentlichen ein elastomeres Bindemittel, eine radikalisch polymerisierbare olefinisch ungesättigte Verbindung und einen Photoinitiator enthält.

7. Verfahren nach einem oder mehreren der Ansprüche 1 bis 5, dadurch gekennzeichnet, daß die Behandlungslösung insbesondere mindestens 50 Gew.-%, vorzugsweise mindestens 80 Gew.-%, insbesondere von einem Polyglykolether der allgemeinen Formel I enthält.

8. Verfahren nach einem oder mehreren der Ansprüche 1 bis 7, dadurch gekennzeichnet, daß die Flexodruckform im wesentlichen aus einem Träger und einem darauf aufgebrachten photopolymerisierbaren elastomeren Gemisch gemäß Anspruch 6 hergestellt worden ist.

9. Verfahren nach einem oder mehreren der Ansprüche 1 bis 8, dadurch gekennzeichnet, daß nach dem bildmäßigen Belichten mit aktinischem Licht die unbelichteten und unvernetzten Schichtenteile mit einem Entwickler entfernt werden, die Schicht getrocknet wird und ggf. mit aktinischem Licht nachbelichtet wird.

**10.** Verfahren nach Anspruch 9, dadurch gekennzeichnet, daß vor der bildmäßigen Belichtung die photopolymerisierbare elastomere Schicht von der gegenüberliegenden Seite kurzzeitig vollflächig mit aktinischem Licht belichtet wird.

**11.** Verfahren nach einem oder mehreren der Ansprüche 1 bis 10, dadurch gekennzeichnet, daß nach dem Entwickeln die ggf. getrocknete Schicht mit Halogen, insbesondere mit Brom, nachbehandelt oder mit aktinischem Licht nachbelichtet wird.

**12.** Verfahren nach einem oder mehreren der Ansprüche 1 bis 11, dadurch gekennzeichnet, daß das Aufbringen des Behandlungsreagenzes auf die entwickelte Flexodruckform entweder durch Auftupfen des Reagenzes erfolgt oder die Flexodruckform in ein Bad, enthaltend das Behandlungsreagenz, getaucht wird.

## Claims

**1.** A method for producing an ozone-resistant flexographic printing form based upon a photopolymerizable elastomeric mixture,
characterized in that
to the developed and, if appropriate, aftertreated flexographic form a treatment reagent is applied, which contains as the essential constituent at least one polyglycol ether of the general formula I

$$R_1 - O - (A)_l - \underset{\left[\begin{array}{c} | \\ D \\ | \\ O \\ | \\ R_3 \end{array}\right]_o}{(B)_m} - (C)_n - R_2 \qquad (I)$$

in which

| | |
|---|---|
| $R_1$ and $R_2$ | are alkyl, especially $(C_1\text{-}C_3)$-alkyl, |
| $R_3$ | is hydrogen or alkyl, especially $(C_1\text{-}C_3)$-alkyl, |
| A, B, C, and D | can be identical or different and are oxa-n- or -iso-alkylene, especially oxa-n- or -iso-$(C_1\text{-}C_5)$-alkylene, and |
| l+m+n+o | is 3 to 40. |

**2.** A method according to claim 1,
characterized in that
in the treatment reagent according to formula I for m and o>0

| | |
|---|---|
| D | is A or C, |
| B | is oxa-n-alkylene, especially oxa-n-($C_3$ or $C_5$)-alkylene, and |
| $R_1$, $R_2$, and $R_3$ | are $(C_1\text{-}C_3)$-alkyl. |

**3.** A method according to claim 1,
characterized in that
in the treatment reagent according to formula I for m = 0 and o = 0 the sum of 1 and n gives 3 to 40 and

| | |
|---|---|
| A and C | are oxa-n- or -iso-$(C_1\text{-}C_5)$-alkylene, especially oxa-n- or -iso-($C_2$ or $C_3$)-alkylene, and |
| $R_1$ and $R_2$ | are $(C_1\text{-}C_3)$-alkyl. |

**4.** A method according to claim 1 or 3,
characterized in that
in the treatment reagent according to formula I for 1 = 0 and m = 0
C is oxa-n- or -iso-$(C_2\text{-}C_5)$-alkylene, especially oxa-n- or -iso-($C_2$ or $C_3$)-alkylene,
and, for m = 0 and n = 0
A is oxa-n- or -iso-$(C_2\text{-}C_5)$-alkylene, especially oxa-n- or -iso-($C_2$ or $C_3$)-alkylene, and in

each case
$R_1$ and $R_2$ are $(C_1\text{-}C_3)$-alkyl, especially methyl.

5. A method according to one or more of claims 1 to 4, characterized in that the treatment reagent according to formula I has a mean molecular weight of 100 to 1400, especially 200 to 1200.

6. A method according to one or more of claims 1 to 5,
characterized in that
the polymerizable elastomeric mixture essentially contains an elastomeric binder, an olefinically unsaturated compound polymerizable by free radicals, and a photoinitiator.

7. A method according to one or more of claims 1 to 5,
characterized in that
the treatment solution contains, in particular, at least 50 % by weight, preferably at least 80 % by weight, of especially a polyglycol ether of the general formula I.

8. A method according to one or more of claims 1 to 7,
characterized in that
the flexographic printing form has essentially been produced from a carrier and, applied thereto, a photopolymerizable elastomeric mixture as claimed in claim 6.

9. A method according to one or more of claims 1 to 8,
characterized in that
after the imagewise exposure to actinic light the unexposed and uncrosslinked layer fractions are removed by means of a developer, the layer is dried, and is optionally afterexposed with actinic light.

10. A method according to claim 9,
characterized in that
before the imagewise exposure the photopolymerizable elastomeric layer is briefly exposed to actinic light on its whole area from the opposite side.

11. A method according to one or more of claims 1 to 10,
characterized in that
after development the optionally dried layer is aftertreated with halogen, in particular with bromine, or is afterexposed to actinic light.

12. A method according to one or more of claims 1 to 11,
characterized in that
application of the treatment reagent to the developed flexographic printing form is either effected by dabbing on the reagent or the flexographic printing form is immersed into a bath which contains the treatment reagent.

## Revendications

1. Procédé de fabrication d'une matrice d'impression flexographique résistant à l'ozone à partir d'un mélange élastomère photopolymérisable, caractérisé en ce que sur la forme développée, et éventuellement ayant été soumise à un traitement ultérieur, est apposée un réactif de traitement qui en tant que constituant principal contient au moins un polyglycoléther présentant la formule générale I

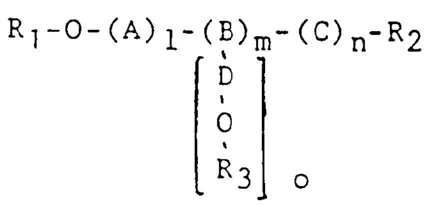

(I)

dans laquelle

| | |
|---|---|
| $R_1$ et $R_2$ | sont des radicaux alkyles, notamment des radicaux alkyles en $C_1$-$C_3$ |
| $R_3$ | est de l'hydrogène ou un radical alkyle, notamment un radical alkyle en $C_1$-$C_3$, |
| A, B, C, et D | identiques ou différents, peuvent être des radicaux oxa-n-alkylènes ou oxa-iso-alkylènes, dans lesquels les radicaux alkylènes comportent 1 à 5 atomes de carbone |
| l+m+n+o | est compris entre 3 et 40, bornes comprises |

**2.** Procédé selon la revendication 1, caractérisé en ce que dans la formule (I) du réactif de traitement, m et o sont supérieurs à zéro,

| | |
|---|---|
| D | est A ou C, |
| B | est un radical oxa-n-alkylène, dont le radical alkylène comporte 3 à 5 atomes de carbone, |
| $R_1$, $R_2$ et $R_3$ | sont des radicaux alkyles en $C_1$-$C_3$. |

**3.** Procédé selon la revendication 1, caractérisé en ce que dans la formule I du réactif de traitement, pour m=0 et o=0 la somme 1 + n est comprise entre 3 et 40 et en ce que

| | |
|---|---|
| A et C | sont des radicaux oxa-n-alkylènes ou oxa-isoalkylènes dans lesquels les radicaux alkylènes comportent de 1 à 5 atomes de carbone, et notamment dans lesquels les radicaux alkylènes comportent 2 ou 3 atomes de carbone, |
| $R_1$ et $R_2$ | sont des radicaux alkyles en $C_1$-$C_3$. |

**4.** Procédé selon la revendication 1 ou 3, caractérisé en ce que dans la formule I du réactif de traitement, quand 1 et m sont égaux à zéro,

| | |
|---|---|
| C | est un radical oxa-n-alkylène ou oxa-iso-alkylène dans lesquels les radicaux alkylènes comportent 2 à 5 atomes de carbone, et notamment 2 ou 3 atomes de carbone, |

et quand m et n sont égaux à zéro

| | |
|---|---|
| A | est un radical oxa-n-alkylène ou oxa-iso-alkylène dans lesquels les radicaux alkylènes comportent 2 à 5 atomes de carbone, et notamment 2 ou 3 atomes de carbone, |
| $R_1$ et $R_2$ | sont des radicaux alkyles en $C_1$-$C_3$, notamment des radicaux méthyles. |

**5.** Procédé selon une ou plusieurs des revendications 1 à 4, caractérisé en ce que le réactif du traitement de formule I présente un poids moléculaire moyen compris entre 100 et 1400; notamment entre 200 et 1200.

**6.** Procédé selon une ou plusieurs des revendications 1 à 5, caractérisé en ce que le mélange élastomère polymérisable contient en proportions majeures un liant élastomère, un composé insaturé oléfinique polymérisable par polymérisation radicalaire et un photoinitiateur.

**7.** Procédé selon une ou plusieurs des revendications 1 à 5, caractérisé en ce que la solution de traitement contient en particulier au moins 50% en poids, et de préférence au moins 80% en poids, de notamment un polyglycoléther présentant la formule générale I.

**8.** Procédé selon une ou plusieurs des revendications 1 à 7, caractérisé en ce que la matrice d'impression flexographique est formée en proportions majeures d'un support, lequel est recouvert d'un mélange élastomère photopolymérisable selon la revendication 6.

**9.** Procédé selon une ou plusieurs des revendications 1 à 8, caractérisé en ce que après exposition à la lumière actinique en vue de former une image, les parties de couches non exposées et non réticulées sont séparées à l'aide d'un révélateur en ce que la couche est séchée et en ce que elle est ensuite soumise à une nouvelle exposition à l'aide de lumière actinique.

**10.** Procédé selon la revendication 9, caractérisé en ce que avant l'exposition en vue de former une image, la couche élastomère photopolymérisable est exposée à une lumière actinique à partir de la face opposée sur la totalité de la face pendant un court intervalle.

**11.** Procédé selon une ou plusieurs des revendications 1 à 10, caractérisé en ce que après développement la couche séchée subit un traitement ultérieur par un halogène, de préférence du brome ou subit une exposition supplémentaire à l'aide de lumière actinique.

**12.** Procédé selon une ou plusieurs des revendications 1 à 11, caractérisé en ce que le recouvrement par le réactif de traitement de la matrice d'impression flexographique exposée est effectué soit par tamponnage avec du réactif soit par immersion de la matrice d'impression flexographique dans un bain contenant le réactif de traitement.